# EUROPÄISCHE PATENTSCHRIFT

(11) **EP 2 256 818 B1**
(45) Veröffentlichungstag und Bekanntmachung des Hinweises auf die Patenterteilung: **17.08.2016**
(21) Anmeldenummer: 10005273.7
(22) Anmeldetag: 20.05.2010
(51) Int. Cl.: H02S 40/34

(54) **Anschlussdose, Solarpaneel und Verfahren**
Connection socket, solar panel and method
Boîte de jonction, panneau solaire et procédé

(30) Priorität: 25.05.2009 DE 102009022570
(43) Veröffentlichungstag der Anmeldung: 01.12.2010
(73) Patentinhaber: Yamaichi Electronics Deutschland GmbH, 85609 Aschheim-Dornach (DE)
(72) Erfinder: Michel, Dirk, 85716 Unterschleissheim (DE); Quiter, Michael, 57482 Wenden (DE)
(74) Vertreter: Müller-Boré & Partner Patentanwälte PartG mbB

(56) Entgegenhaltungen:
- EP-A1- 1 777 754
- WO-A2-2007/048421
- DE-U1-202005 014 032
- US-A- 4 725 558

## Beschreibung

Die Erfindung betrifft eine Anschlußdose, ein Solarpaneel und ein Verfahren.

Herkömmliche Solarmodule zur Erzeugung elektrischer Energie aus Sonnenlicht umfassen eine oder mehrere einzelne Solarzellen. Je nach gewünschter vom Solarmodul zur Verfügung zu stellenden Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt. Die elektrischen Anschlüsse der Solarzellengruppen des Solarmoduls werden nach außen geführt.

Bei partieller Verringerung der Bestrahlungsintensität durch Sonnenlicht auf einzelne Solarzellen bzw. Solarzellengruppen, beispielsweise durch Verschmutzung oder Schattenwurf, können unter anderem folgende Effekte auftreten: (1) Eine (gleichmäßige) Verringerung der Bestrahlungsintensität innerhalb der zusammen geschalteten Solarzellengruppen führt zu einer Leistungsverminderung der jeweiligen Solarzellengruppe. (2) Durch eine partielle Abschattung einer Solarzelle innerhalb einer Solarzellengruppe wirkt diese abgeschattete Solarzelle als Sperrdiode bzw. Widerstand innerhalb des Stromkreises der Solarzellengruppe, was zum einen dazu führen kann, daß die gesamte Solarzellengruppe keine elektrische Energie mehr liefern kann und zum anderen zu einer Beschädigung der abgeschatteten Solarzelle und damit zum dauerhaften Ausfall der Solarzellengruppe führen kann. In jedem Fall können zwischen den herausgeführte Anschlüssen der Solarzellengruppen eines Solarmoduls, je nach Bestrahlungsintensität auf die einzelnen Solarzellen, unterschiedliche Spannungen anliegen. Eine Reihenschaltung der Solarzellengruppen durch entsprechende Schaltung der nach außen geführten Anschlüsse führt analog zu den oben genannten Problemen.

Um die mit der unterschiedlichen Bestrahlungsintensität der Solarzellen verbundenen Probleme zu vermeiden, werden herkömmlich sogenannte Bypass-Dioden, verwendet, die elektrisch antiparallel zu den Solarzellengruppen geschaltet werden. Diese Bypass-Dioden haben die Wirkung, daß der Stromfluß durch das Solarmodul an Solarzellengruppen, welche eine nur geringe Leistung liefern, vorbei geleitet wird, d.h. die Anschlüsse dieser Solarzellengruppe eines Solarmoduls werden durch die Bypass-Diode kurz geschlossen und die entsprechende Solarzellengruppe dadurch überbrückt. Somit liefert eine solche Solarzellengruppe zwar keinen Anteil mehr zur Gesamtleistung des Solarmoduls, der Gesamtstromfluß durch das Solarpaneel ist jedoch im wesentlichen ungehindert und eine Beschädigung einzelner Solarzellen wird verhindert.

Solarpaneele, umfassen daher neben dem Solarmodul in der Regel eine elektrische Anschlußdose mit zumindest zwei Kontaktvorrichtungen und zumindest einer Bypass-Diode. Die Solarzellen in einem Solarmodul sind in der Regel durch flache dünne Leiterbänder miteinander verbunden. Diese Leiterbänder werden aus dem Solarmodul heraus geführt und mit einem in der Anschlußdose angeordneten elektrischen Leiterkontakt verbunden. Um die von dem Solarmodul erzeugte elektrische Energie einem Verbraucher zur Verfügung zu stellen, weist die Anschlußdose zwei Anschlußpole auf, d.h. einen Plus- und einen Minuspol zwischen denen im Betrieb eine elektrische Spannung anliegt. Das mit der Anschlußdose versehene Solarmodul wird als Solarpaneel bezeichnet.

Während des Betriebes und bei Anschließen bzw. Abklemmen eines Solarpaneels können aufgrund induzierter Ströme, beispielsweise aufgrund von Gewittern oder Leitungsinduktivitäten, Spannungsspitzen an den Solarzellen bzw. den Bypass-Dioden anliegen und diese beschädigen oder völlig zerstören. Daher ist die Betriebssicherheit und die Lebensdauer des Solarpaneels durch derartige Spannungsspitzen verringert.

Die Druckschrift EP 1 777 754 A1 offenbart eine Anschlußdose für ein Solarmodul mit einer Vielzahl von elektrische Kontaktvorrichtungen zum Kontaktieren elektrischer Leiter des Solarmoduls und einer Vielzahl, von Bypass-Dioden, welche jeweils zwei benachbarte Kontaktvorrichtungen elektrisch verbinden.

Die Druckschrift DE 20 2005 014 032 U1 offenbart eine solarbetriebene Spannungstreiberstufe für den Betrieb von Solarmotoren.

Es ist eine Aufgabe der Erfindung, eine elektrische Anschlußdose und ein Solarpaneel bereitzustellen, welche eine erhöhte Betriebssicherheit bei Beaufschlagung mit Überspannungen aufweist.

Die Aufgabe wird durch die elektrische Anschlußdose gemäß Anspruch 1, das Solarpaneel gemäß Anspruch 11 sowie das Verfahren zum Herstellen der Anschlußdose gemäß Anspruch 12 gelöst. Bevorzugte Ausführungsformen sind Gegenstand der abhängigen Ansprüche.

### Anschlußdose gemäß einem Aspekt

Ein Aspekt der vorliegenden Erfindung betrifft eine Anschlußdose für ein Solarmodul umfassend:
- einen ersten und zweiten elektrischen Anschlußpol,
- zumindest drei elektrische Kontaktvorrichtung, wobei eine jede der zumindest drei elektrischen Kontaktvorrichtungen mit einem zugeordneten elektrischen Leiter des Solarmoduls kontaktierbar ist,
- zumindest zwei Bypass-Dioden, und
- zumindest eine Überspannungsschutz-Diode,
wobei die erste der zumindest zwei Bypass-Dioden die erste Konfaktvorrichtung mit der zweiten Kontaktvorrichtung und die zweite der zumindest zwei Bypass-Dioden die zweite Kontaktvorrichtung mit der dritten Kontaktvorrichtung elektrisch verbindet, und wobei die zumindest eine Überspannungsschutz-Diode parallel zu zumindest einer der Bypass-Dioden geschaltet ist, wobei die Ansprechzeit der zumindest einen Überspannungsschutz-Diode kleiner ist als die Ansprechzeit der Bypass-Dioden, um die Bypass-Dioden vor Überspannungen zu schützen.

In anderen Worten ist die erste der zumindest drei elektrischen Kontaktvorrichtungen mit dem ersten elektrischen Leiter des Solarmoduls kontaktierbar, ist die zweite der zumindest drei elektrischen Kontaktvorrichtungen mit dem zweiten elektrischen Leiter des Solarmoduls kontaktierbar und ist die dritte der zumindest drei elektrischen Kontaktvorrichtungen mit dem dritten elektrischen Leiter des Solarmoduls kontaktierbar.

Der erste und zweite Anschlußpol sind ausgelegt, ein an die Anschlußdose angeschlossenes Solarmodul mit einem elektrischen Verbraucher zu verbinden. Da das Solarmodul eine Gleichspannung erzeugt, kann der erste Anschlußpol mit "-" bzw. als Minuspol und der zweite Anschlußpol mit "+" bzw. als Pluspol bezeichnet werden. Im Betrieb fließt innerhalb der Anschlußdose und des Solarmoduls, d.h. innerhalb der Stromquelle, der Strom I entlang der technischen Stromrichtung vom Minuspol zum Pluspol.

Das Solarmodul, welches ausgelegt ist mit der Anschlußdose zu kontaktieren, weist zumindest drei elektrische Leiter auf, wobei die zumindest drei elektrischen Kontaktvorrichtungen der Anschlußdose ausgelegt sind mit einem Solarmodul mit zumindest drei elektrischen Leitern kontaktierbar zu sein.

Die Anschlußdose weist ferner zumindest zwei Bypass-Dioden auf, wobei die Bypass-Dioden jeweils zwei der zumindest drei elektrischen Kontaktvorrichtungen miteinander elektrisch verbinden. Dabei sind die Bypass-Dioden ausgelegt eine niederohmige Verbindung bzw. einen Kurzschluß zwischen den entsprechenden zwei Kontaktvorrichtungen herzustellen, welche durch die Bypass-Diode verbunden werden, wenn zwischen diesen zwei Kontaktvorrichtungen eine vorbestimmbare Spannung anliegt. In diesem Fall, d.h. wenn die Spannung zwischen den zwei Kontaktvorrichtungen einen vorbestimmbaren Schwellwert überschreitet, so überschreitet auch die über die Bypass-Diode abfallenden Spannung diesen Schwellwert. Dadurch verliert die Bypass-Diode ihre Sperrwirkung und stellt einen Kurzschluß zwischen den zwei Kontaktvorrichtungen her.

Vorteilhafterweise fließt im Betrieb der Gesamtstrom in diesem Fall nicht über das Solarmodul, sondern über die Bypass-Diode, wodurch in dem angeschlossenen Solarmodul kein elektrischer Leistungsverlust bzw. keine Erwärmung auftritt. Das Überschreiten der vorbestimmbaren Spannung zwischen zwei Kontaktvorrichtungen kann im Betrieb dadurch auftreten, daß eine Solarzellengruppe des Solarmoduls, welche an den zwei elektrischen Kontaktvorrichtungen der Anschlußdose angeschlossen ist, abgeschattet wird und daher keine ausreichende elektrische Leistung erzeugt.

Die Anschlußdose umfaßt weiter zumindest eine Überspannungsschutz-Diode, welche zumindest zu einer der Bypass-Dioden parallel geschaltet ist.

Eine Überspannungsschutz-Diode ist eine Halbleiterdiode, die zum Schutz vor Überspannungen bzw. unerlaubten Spannungen eingesetzt wird. Überspannungen können beispielsweise aufgrund von Induktivitäten der Anschlußdose, des daran angeschlossenen Solarmoduls und/oder des an den Anschlußpolen angeschlossenen Verbrauchers bzw. den zu diesem führenden elektrischen Leitungen auftreten. Überspannungen können insbesondere auftreten, sobald eine elektrische Leitung getrennt wird.

Zum Schutz vor einer Überspannung beim Abschalten einer induktiven Gleichspannungslast, wird die Überspannungsschutz-Diode (in diesem Fall auch Freilauf-Diode genannt) derart parallel zu dem induktiven Element geschaltet, daß sie von dem im Betrieb fließenden Strom I in Sperrichtung beansprucht werden.

Beim Lösen von mit den Anschlußpolen kontaktierenden elektrischen Leitungen, beispielsweise bei Montagearbeiten an dem Solarpaneel, wird der im Betrieb ausgebildete Stromkreis unterbrochen, wobei aufgrund der Selbstinduktion eines induktiven Elementes ein Stromfluß in der ursprünglichen Richtung des Stromes I erzeugt wird. Ohne Überspannungsschutz-Diode führt das zu einer Spannungsspitze, die sich zur Betriebsspannung addiert und die elektronischen Bauteile schädigen oder zerstören kann. Vorteilhafterweise wird aufgrund der Überspannungsschutz-Diode die Spannungsspitze jedoch auf die Durchlaßspannung der Überspannungsschutz-Diode begrenzt. Das schützt die elektronischen Bauteile vorteilhafterweise vor Überspannung, da der Strom über die Überspannungsschutz-Diode fließt.

Der Begriff "Kontakt" im Sinne der vorliegenden Erfindung beinhaltet insbesondere elektrischen und/oder mechanischen Kontakt.

### Bevorzugte Ausführungsformen der Anschlußdose

Vorzugsweise verbindet genau eine Überspannungsschutz-Diode den ersten Anschlußpol mit dem zweiten Anschlußpol elektrisch. Insbesondere ist die eine Überspannungsschutz-Diode zu allen Bypass-Dioden parallel geschaltet. Bevorzugt ist die Überspannungsschutz-Diode unmittelbar mit dem ersten und/oder dem zweiten Anschlußpol kontaktiert, insbesondere verlötet. Vorteilhafterweise ist lediglich eine Überspannungsschutz-Diode notwendig, um alle der zumindest zwei Bypass-Dioden zu schützen, wodurch der Montageaufwand und der Materialverbrauch gering gehalten ist.

Vorzugsweise umfaßt die Anschlußdose:
- N elektrische Kontaktvorrichtungen, welche jeweils mit einem zugeordneten elektrischen Leiter des Solarmoduls kontaktierbar sind,
- N-1 Bypass-Dioden, und
- N-1 Überspannungsschutz-Dioden,
wobei jeweils zwei elektrische Kontaktvorrichtungen durch eine Bypass-Diode und eine dazu parallel geschaltete Überspannungsschutz-Diode elektrisch verbunden sind.

Vorteilhafterweise ist zu jeder Bypass-Diode eine zugeordnete Überspannungsschutz-Diode parallel geschaltet, so daß jede Bypass-Diode einzeln geschützt ist. Die Anzahl N der elektrischen Kontaktvorrichtungen kann dabei 3, 4, 5, 6, 7, 8, 9, 10 oder jede weitere natürliche Zahl sein, so daß die Anzahl N-1 der Bypass-Dioden 2, 3, 4, 5, 6, 7, 8, usw. ist.

Vorzugsweise ist ein Gehäuse der Anschlußdose spritzgegossen, wobei die Bypass-Dioden und die Überspannungsschutz-Diode(n) in dem Gehäusematerial der Anschlußdose eingebettet sind und von dem Gehäusematerial der Anschlußdose umgeben sind. Vorzugsweise wird beim Spritzgießen des Gehäuses flüssiges, insbesondere thermisch geschmolzenes Gehäusematerial verwendet. Die Schmelztemperatur des Gehäusematerials beträgt hierbei zwischen etwa 250°C und etwa 400°C, insbesondere zwischen etwa 300°C und etwa 350°C. Das geschmolzene Gehäusematerial wird auf bzw. um die Dioden, d.h. um die Bypass-Dioden und die Überspannungsschutz-Diode(n) gespritzt. Da die Dioden an den Kontaktvorrichtung, die als Leiterplatte ausgebildet sein können, angeordnet sind, wird das geschmolzene Gehäusematerial zumindest bereichsweise auch um die Kontaktvorrichtungen bzw. die Leiterplatte(n) gespritzt. Somit werden die Dioden und zumindest ein Bereich der Kontaktvorrichtungen bzw. der Leiterplatte(n) vollständig von dem geschmolzenen Gehäusematerial umgeben und in dieses eingebettet und somit insbesondere feuchtigkeitsdicht von der Umgebung abschlossen. Das geschmolzene Gehäusematerial kühlt anschließend aus und erstarrt, wobei das Gehäuse gebildet wird. Die Anschlußdose kann zu einem späteren Zeitpunkt an einem Solarmodul angeordnet und angeschlossen werden. Gegebenenfalls kann ein Hohlraum bzw. eine Öffnung in dem Gehäuse, der zum Anschluß der Anschlußdose an dem Solarmodul notwendig ist mit Kunstharz ausgegossen werden und/oder es kann ein Deckel an dem Gehäuse angeordnet werden.

Überraschenderweise wurde festgestellt, daß die Dioden von dem geschmolzenen Gehäusematerial umgeben und in dieses eingebettet sein können, obwohl die maximale Betriebstemperatur der Dioden wesentlich niedriger ist, insbesondere im Bereich zwischen etwa 100°C und etwa 200°C, insbesondere zwischen etwa 130°C und etwa 170°C liegt. Ferner wurde überraschenderweise festgestellt, daß im Betrieb der Anschlußdose die durch die Dioden erzeugte Wärme ausreichend aus der Anschlußdose abgeleitet werden kann, obwohl die Dioden in das Gehäusematerial eingebettet sind. Somit kann die Anschlußdose in sehr einfacher und kosteneffizienter Weise hergestellt werden, da als Kontaktvorrichtungen bzw. als Leiterplatte Stanzbauteile verwendet werden können, das Gehäuse nicht vorgefertigt werden muß und die elektrischen Bauelemente, d.h. die Kontaktvorrichtungen bzw. die Leiterplatte und die Dioden nicht in einem vorgefertigten Gehäuse angeordnet werden müssen. Vielmehr können in einfacher Weise die Dioden an den Kontaktvorrichtungen bzw. der Leiterplatte angeordnet werden, gegebenenfalls Kontakte an den Kontaktvorrichtungen bzw. der Leiterplatte unterbrochen werden, wobei hierfür z.B. Sollbruchstellen vorgesehen sein können, und die mit den Dioden bestückten Kontaktvorrichtungen bzw. Leiterplatte mit geschmolzenem Gehäusematerial umgeben werden. Insbesondere können die Kontaktvorrichtungen durch Trennen der Leiterplatte hergestellt werden. Das Anordnen des Gehäusematerials kann bei hohem Druck und hoher Temperatur erfolgen.

Der Begriff "feuchtigkeitsdicht", wie er in dieser Anmeldung verwendet wird, beinhaltet, daß insbesondere keine Leck- bzw. Kriechströme durch Eindringen von Feuchtigkeit aus dem Inneren der Anschlußdose nach Außen, d.h. an die Umgebung dringen können. Der Begriff "feuchtigkeitsdicht", wie er in dieser Anmeldung verwendet wird, beschreibt somit insbesondere, daß die Anschlußdose insbesondere eine Feuchtigkeitsprüfung gemäß IP 67, besonders bevorzugt IP 68 besteht.

Der Begriff "feuchtigkeitsdicht" wie er im Sinne der vorliegenden Anmeldung verwendet wird, kann eine Dichtheit bzw. eine Barriere gegenüber einem Fluid, insbesondere Wasser und/oder Wasserdampf beschreiben. Feuchtigkeitsdichtheit wird erreicht, wenn die Migration, d.h. das Fließen bzw. Verlagern der Feuchtigkeit aufgrund einer Partialdruckdifferenz bzw. der Druckdifferenz (insbesondere bei einer Druckdifferenz von etwa 10kPa) bzw. der Diffusion verhindert bzw. hinreichend verlangsamt wird. Hinreichend langsam bedeutet insbesondere, daß die Fließgeschwindigkeit des Fluids in einem Körper innerhalb von Poren oder entlang von kanalförmigen der flächigen präferentiellen Fließwegen vorzugsweise einen Wert von etwa 1 m pro Stunde, von etwa 1cm pro Stunde, von etwa 1 mm pro Tag, weiter bevorzugt etwa 1 mm pro Jahr, besonders bevorzugt 0,1 mm pro Jahr, insbesondere 0,01 mm pro Jahr nicht überschreitet.

In anderen Worten wird durch das Einbetten der Dioden in das Gehäusematerial ein Eindringen von Feuchtigkeit in das Innere der Anschlußdose, insbesondere zu den Dioden und/oder zu den elektrischen Kontaktvorrichtungen hin verhindert. Somit wird erreicht, daß die Anschlußdose eine hohe Feuchtigkeitsdichte, insbesondere gemäß IP 67, besonders bevorzugt IP 68 aufweist, und dies bei einer sehr kompakten Baugröße.

Vorzugsweise ist die Überspannungsschutz-Diode eine Supressor-Diode, eine bipolare Supressor-Diode, eine Zener-Diode, eine Schottky-Diode oder ein Varistor. Hierbei ist es nicht notwendig, daß bei einer Mehrzahl Überspannungsschutz-Dioden alle Dioden vom gleichen Typ sind. Vielmehr ist es möglich, daß Überspannungsschutz-Dioden verschiedenen Typs bzw. verschiedener Art in ein und der selben Anschlußdose eingesetzt werden.

Vorzugsweise sind zumindest zwei der elektrischen Kontaktvorrichtungen mittels zumindest einer Überspannungsschutz-Diode mechanisch verbunden. Weiter vorzugsweise sind zumindest zwei der elektrischen Kontaktvorrichtungen mittels zumindest einer Bypass-Diode mechanisch verbunden. Beispielsweise können die zwei Kontaktvorrichtungen diskrete voneinander getrennte Bauteile sein, an welche die Bypass-Diode bzw. die Überspannungsschutz-Diode befestigt, insbesondere gelötet, ist bzw. sind, so daß beide Kontaktvorrichtungen mechanisch miteinander verbunden sind. Hierbei ist es möglich, daß die zwei Kontaktvorrichtungen ursprünglich aus einem Bauelement bestanden und nach Anordnung der Dioden zu zwei Kontaktvorrichtungen vereinzelt wurden.

Vorzugsweise sind die zumindest eine Bypass-Diode und die zumindest eine Überspannungsschutz-Diode an einer Leiterplatte angeordnet. Die Kontaktvorrichtung ist somit Bestandteil der Leiterplatte. Vorteilhafterweise können die notwendigen elektronischen Bauteile durch Löten, Schweißen, Kleben, usw. einfach und sicher an der Leiterplatte befestigt werden. Beispielsweise kann die Leiterplatte ein sogenanntes "printed circuit board" sein. Es ist auch möglich, daß die Leiterplatte ein Stanzbauteil ist, insbesondere ein Blechbauteil sein, beispielsweise aus Kupfer-, Eisen-, Metallegierungsblech, mit oder ohne einer Metallbeschichtung, das in die gewünschte Form gestanzt ist.

Vorzugsweise ist die Anschlußdose mit einem Kunstharz ausgegossen. Vorteilhafterweise sind die elektronischen Bauteile innerhalb der Anschlußbox durch das Ausgießen mit Kunstharz gegen Feuchtigkeit isoliert und vor Korrosion geschützt.

Vorzugsweise ist die Überspannungsschutz-Diode bzw. die Bypass-Diode als SMD-Bauteil ausgebildet. Insbesondere in Anschlußdosen, die mit Kunstharz ausgegossen sind, weisen SMD Bauteile bessere thermische Eigenschaften auf, da sie im Gegensatz zu Bauteilen in axialer Bauweise eine größere Oberfläche aufweisen, über die Wärme an das umgebende Kunstharz abgegeben werden kann. Vorteilhafterweise gilt dies auch, wenn das SMD-Bauteil in das Gehäusematerial eingebettet ist.

### Solarpaneel gemäß einem Aspekt

Ein weiterer Aspekt der vorliegenden Erfindung betrifft ein Solarpaneel umfassend:
- zumindest ein im wesentlichen plattenförmiges Solarmodul und
- zumindest eine Anschlußdose gemäß einem der vorangegangenen Ansprüche, wobei das Solarmodul zumindest drei elektrische Leiter umfaßt und die zumindest drei elektrischen Leiter jeweils mit einer zugeordneten elektrischen Kontaktvorrichtung der Anschlußdose verbunden sind.

In anderen Worten kann das Solarpanel umfassen: ein Solarmodul mit einem im wesentlichen plattenförmigen Körper mit zumindest zwei spannungserzeugenden Solarzellen, zumindest drei mit den zumindest zwei Solarzelle verbundenen Leiterbänder, die an einer Oberfläche des Solarmoduls aus diesen herausgeführt sind und zumindest eine erfindungsgemäße Anschlußdose.

### Verfahren gemäß einem Aspekt

Ein Aspekt weiterer Aspekt der vorliegenden Erfindung betrifft ein Verfahren zum Herstellen einer Anschlußdose mit den Schritten:
- Bereitstellen zumindest dreier elektrischer Kontaktvorrichtungen, wobei jede der zumindest drei elektrischen Kontaktvorrichtungen mit einem zugeordneten elektrischen Leiter eines Solarmoduls kontaktierbar ist,
- Anordnen zumindest zweier Bypass-Dioden an den zumindest drei elektrischen Kontaktvorrichtungen, wobei die erste der zumindest zwei Bypass-Dioden die erste Kontaktvorrichtung mit der zweiten Kontaktvorrichtung und die zweite der zumindest zwei Bypass-Dioden die zweite Kontaktvorrichtung mit der dritten Kontaktvorrichtung elektrisch verbindet,
- Anordnen zumindest einer Überspannungsschutz-Diode, wobei die zumindest eine Überspannungsschutz-Diode parallel zu zumindest einer der Bypass-Dioden geschaltet ist, und
- Ausbilden eines Gehäuses der Anschlußdose mittels flüssigem Gehäusematerial, wobei die Bypass-Dioden und die Überspannungsschutz-Diode(n) in dem Gehäusematerial der Anschlußdose eingebettet sind und von dem Gehäusematerial der Anschlußdose umgeben sind.

Nach dem Anordnen der Dioden kann das Verfahren auch noch den Schritt umfassen: Trennen der elektrischen Kontaktvorrichtungen voneinander. Die Kontaktvorrichtungen sind nach dem Trennen lediglich durch die Dioden elektrisch verbunden. Die Dioden verbinden die Kontaktvorrichtungen auch mechanisch.

### Verwendung gemäß Aspekt

Ein weiterer Aspekt der vorliegenden Erfindung betrifft die Verwendung einer Anschlußdose mit den oben beschriebenen Merkmalen, zur Anordnung an einem Solarmodul als Eingangs- oder Ausgangsanschlußdose. Dabei wird die Anschlußdose an einer Anschlußseite des Solarmoduls angeordnet. Insbesondere kann danach die Anschlußdose mit dem Solarmodul elektrisch verbunden werden. Weiterhin kann die Anschlußdose verwendet werden, um das Solarmodul mit weiteren Solarmodulen oder elektrischen Verbrauchern zu verbinden.

### Figurenbeschreibung

Nachfolgend werden bevorzugte Ausführungsformen der vorliegenden Erfindung anhand der beigefügten Zeichnungen beispielhaft erläutert. Es zeigen:
- Figur 1:: eine perspektivische Ansicht einer Ausführungsform einer Anschlußdose;
- Figur 2:: ein elektrisches Schaltbild der in Figur 1 gezeigten Ausführungsform;
- Figur 3:: eine perspektivische Ansicht einer weiteren Ausführungsform der Anschlußdose;
- Figur 4:: eine schematische Ansicht einer weiteren Ausführungsform der Anschlußdose; und
- Figur 5:: ein elektrisches Schaltbild der in Figur 3 und in Figur 4 gezeigten Ausführungsform.

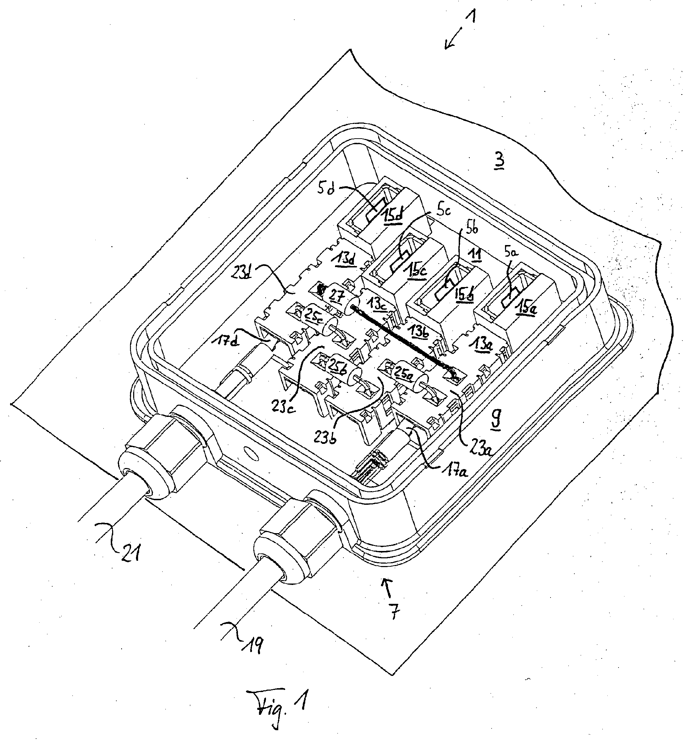

Figur 1 zeigt eine perspektivische Ansicht einer Ausführungsform eines Solarpaneels 1 mit einem plattenförmigen Solarmodul 3, wobei auf einer Bestrahlungsseite des Solarmoduls 3 zumindest eine spannungserzeugende Solarzelle angeordnet ist, deren elektrische Leitungen 5a-5d in Form von Leiterbändern, welche auf der Anschlußseite, welche der Bestrahlungsseite gegenüberliegend bzw. entgegengesetzt ist, aus dem Solarmodul 3 herausgeführt werden. Es ist jedoch auch möglich, die elektrischen Leitungen auf der Bestrahlungsseite heraus zu führen.

Eine Anschlußdose 7 ist an bzw. auf der Anschlußseite des Solarmoduls 3 an bzw. auf diesem angeordnet. Die Anschlußdose 7 weist ein Gehäuse 9 auf, welches einen Öffnungsbereich 11 und einen Deckel (nicht gezeigt) zum Verschließen der Anschlußdose 7 umfaßt. Das Gehäuse 9 kann bevorzugt mittels eines Klebemittels an dem Solarmodul 3 befestigt sein.

Vorzugsweise weist in diese Ausführungsform vier elektrisch leitfähige Kontaktvorrichtungen 13a-13d auf. Daher kann jede der vier elektrischen Leitungen bzw. Leiter 5a-5d des Solarmoduls 3 mit einem zugeordneten Leiterkontakt 15a-15d der zugeordneten Kontaktvorrichtung 13a-13d kontaktiert werden. Dazu sind die elektrischen Leitungen 5a-5d des Solarmodul 3 vorzugsweise durch einen gemeinsamen Öffnungsbereich 11 in das Gehäuse 9 geführt.

Zwei Kontaktvorrichtungen 13a, 13d umfassen jeweils einen Anschlußbereich 17a, 17d. An den Anschlußbereichen 17a, 17d angeordnet befinden sich die Anschlußpole 19, 21, die in dieser Ausführungsform als Anschlußkabel ausgebildet sind. Alternativ können die Anschlußpole 19, 21 jeweils als Verbinder ausgebildet sein oder als Kontakte eines Verbinders.

Die Kontaktvorrichtungen 13a-13d weisen jeweils einen Kurzschlußbereich 23a-23d auf, der ausgelegt ist, um eine Kontaktvorrichtung 13a-13d mit einer oder mehreren weiteren Kontaktvorrichtungen 13a-13d elektrisch zu verbinden. Die Kurzschlußbereiche 23a-23d zweier benachbarter Kontaktvorrichtungen 13a-13d sind jeweils durch Bypass-Dioden 25a-25c elektrisch miteinander verbunden.

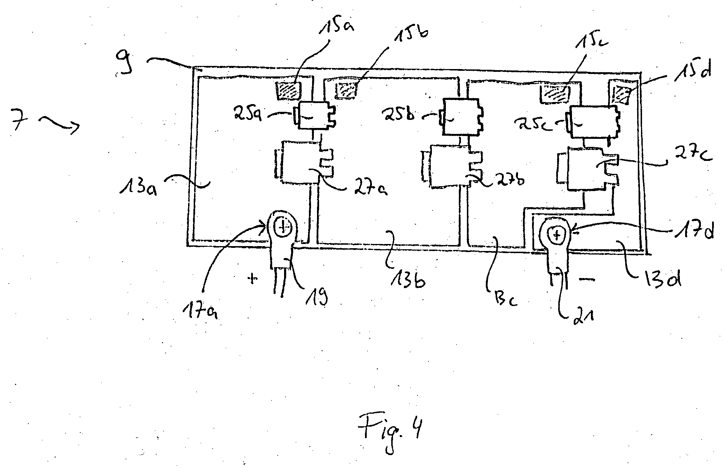

Die Kontaktvorrichtungen 13a-13d sind zwar als komplexes Bauteil dargestellt. Die Kontaktvorrichtungen 13a-13d können jedoch einfacher ausgebildet sein, wie z.B. in Figur 4 gezeigt. Insbesondere können die Kontaktvorrichtungen 13a-13d aus einem gestanzten, vorzugsweise flachen Metallblech gebildet sein. Hierbei ist es insbesondere möglich, daß jede Kontaktvorrichtung der Kontaktvorrichtungen 13a-13d aus einem einstückigen, monolithischen Blechteil besteht. Somit kann das Blechteil den Anschlußbereich, den Kurzschlußbereich und den Leiterkontakt umfassen. In diesem Fall ist die Kontaktvorrichtung besonders einfach und kostengünstig herzustellen.

Um die Bypass-Dioden 25a-40c vor Spannungsspitzen zu schützen, ist parallel zu den in Reihe geschalteten Bypass-Dioden 25a-40c eine Überspannungsschutz-Diode 27 geschaltet, wobei die Kontaktvorrichtungen 13a, 13d, an denen die Anschlußpole 19, 21 angeschlossen sind, mittels der Überspannungsschutz-Diode, insbesondere unmittelbar, elektrisch verbunden werden.

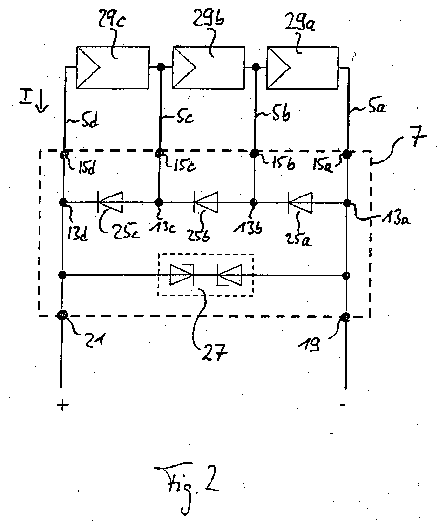

Figur 2 zeigt das elektrische Schaltbild der in Figur 1 gezeigten Ausführungsform der Anschlußdose 7. Das Solarmodul 3 weist drei Solarzellengruppen 29a-29c auf, welche durch die elektrischen Leiter 5a-5d mit den elektrischen Leiterkontakten 15a-15d der Kontaktvorrichtungen 13a-13d verbunden sind. Zwei benachbarte Kontaktvorrichtungen 13a-13d sind somit über eine der Solarzellengruppen 29a-29c des Solarmoduls 3 miteinander elektrisch verbunden. Die Sperrichtung der Bypass-Dioden 25a-25c sind jeweils antiparallel zu der Stromrichtung des Stroms I geschaltet, der über die Solarzellengruppen 29a-24c des Solarmoduls 3 zwischen den benachbarten Kontaktvorrichtungen 13a-13d fließt.

Sollte beispielsweise aufgrund einer Abschattung die elektrische Verbindung, welche über die Solarzellengruppe 29b verläuft, einen Widerstand aufweisen, so daß der Spannungsabfall einen vorbestimmbaren Schwellwert überschreitet, so überschreitet auch der Spannungsabfall zwischen den Anschlußbereichen der entsprechenden benachbarten Kontaktvorrichtungen 13a, 13c einen davon abhängigen Schwellwert. Bei Überschreitung des vorbestimmbaren Schwellwerts, verliert die entsprechende Bypass-Diode 25b ihre Sperrwirkung und stellt einen Kurzschluß zwischen den benachbarten Kontaktvorrichtungen 13a, 13c her. Vorzugsweise fließt der Gesamtstrom des Solarpaneels dadurch nicht durch die überbrückte Solarzellengruppe 29b, wodurch dort weder elektrische Leistungsverluste durch den erhöhten Widerstand der Solarzellengruppe noch eine Beschädigung der Solarzellengruppe, beispielsweise durch Erwärmung aufgrund der elektrischen Verlustleistung, auftreten. Vielmehr fließt der elektrische Strom durch die Bypass-Diode 25b.

Die Bypass-Dioden 25a-25c sind in Reihe geschaltet und stellen eine elektrische Verbindung zwischen den Anschlußpolen 19, 21 her. Um die Bypass-Dioden 25a-25c vor Überspannungen zu schützen, die beispielsweise aufgrund von Induktivitäten auftreten, wenn die Anschlußpole 19 und 21 von einem Verbraucher getrennt oder daran angeschlossen werden, ist eine bipolare Überspannungsschutz-Diode 27, bevorzugt eine sogenannte bipolare Supressor-Diode, derart parallel zu den Bypass-Dioden geschaltet, daß die Anschlußpole 19, 21 durch die Überspannungsschutz-Diode 27 miteinander elektrisch kontaktiert sind.

Für den Fall, daß zwischen den Anschlußpolen 19, 21 eine Spannungsspitze anliegt, typischerweise größer als 100 Volt, überbrückt die Überspannungsschutz-Diode 27 die in Reihe geschalteten Bypass-Dioden 25a-25c, so daß ein Kurzschluß zwischen den Anschlußpolen 19, 21 hergestellt wird. Der aufgrund der Spannungsspitze fließende elektrische Strom wird dadurch über die Überspannungsschutz-Diode 27 geleitet, so daß Bypass-Dioden 25a-25c geschützt sind. Vorzugsweise ist der ohmsche Widerstand über die Überspannungsschutz-Diode 27 geringer als über die in Reihe geschalteten Bypass-Dioden 25a-25c. Weiter bevorzugt ist die Ansprechzeit der Überspannungsschutz-Diode 27 kleiner als die Ansprechzeit der Bypass-Dioden 25a-25c.

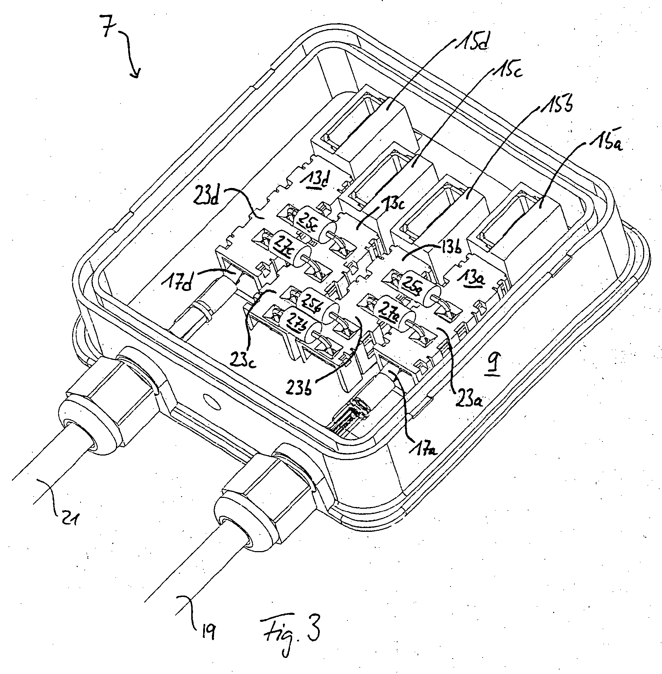

Figur 3 zeigt eine Ausführungsform der Anschlußdose 7, die nur geringfügig von der in Figur 1 gezeigten Ausführungsform abweicht, wobei die zu Figur 1 beschriebenen Merkmale in Figur 3 mit gleichen Bezugszeichen wie in Figur 1 bezeichnet sind.

Wie in Figur 1 sind benachbarte Kontaktvorrichtungen 13a-13d jeweils durch Bypass-Dioden 25a-25c elektrisch miteinander verbunden. Im Gegensatz zu der Ausführungsform in Figur 1 ist zu jeder einzelnen Bypass-Diode 25a-40c eine Überspannungsschutz-Diode 27a-27c parallel geschaltet. Die Anzahl der Überspannungsschutz-Diode 27a-27c ist demnach gleich der Anzahl der Bypass-Dioden 25a-25c.

Figur 4 zeigt eine schematische Ansicht einer weiteren Ausführungsform einer Anschlußdose 7. Die in Figur 4 gezeigte Anschlußdose 7 ist ähnlich wie die in Figur 3 gezeigte Anschlußdose 7 aufgebaut. Die Anschlußdose 7 umfaßt ein Gehäuse 9 mit vier darin angeordneten Kontaktvorrichtungen 13a-13d, die jeweils als flaches Blechstanzelement ausgebildet sind. Die Kontaktvorrichtungen 13a-13d umfassen jeweils Leiterkontakte, Kurzschlußbereiche und Anschlußbereiche 17a, 17d. Da die Kontaktvorrichtungen 13a-13d vorzugsweise einstückig monolithisch sind, sind die Leiterkontakte und die Kurzschlußbereiche integrale Bestandteile der Kontaktvorrichtungen 13-13d. Daher sind die Leiterkontakte und die Kurzschlußbereiche nicht gesondert dargestellt. Ferner sind in Figur 4 Bypass-Dioden 25a-25c und Überspannungsschutz-Dioden 27a-27c gezeigt. Die Anschlußpole 19, 21 sind an den entsprechenden Anschlußbereichen 17a, 17d mit den Kontaktvorrichtungen 13a, 13d verbunden.

Das in Figur 4 gezeigt Gehäuse 9 kann aus einem Gehäusematerial spritzgegossen sein, so daß insbesondere die Kontaktvorrichtungen 13a-13d, die Bypass-Dioden 25a-25c und die Überspannungsschutz-Dioden 27;27a-27c in das Gehäusematerial eingebettet sind. In diesem Fall können die Anschlußbereiche 17a, 17d und die Leiterkontakte freigelegt sein, um die entsprechenden elektrischen Kontakte zu ermöglichen. Es ist auch möglich, daß beispielsweise die Anschlußbereiche, 17a, 17d und die daran angeschlossenen Anschlußpole 19, 21 in das Gehäusematerial und somit in das Gehäuse 9 eingebettet sind.

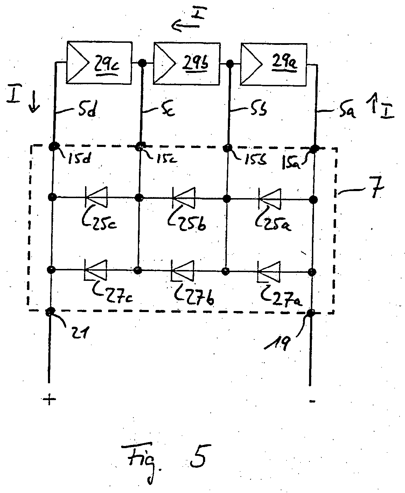

Figur 5,zeigt das elektrische Schaltbild der in Figur 3 gezeigten Ausführungsform der Anschlußdose 7, welches im wesentlich dem in Figur 2 gezeigten Schaltbild entspricht.

Wieder sind die Bypass-Dioden 25a-25c in Reihe geschaltet, wobei zu jeder der Bypass-Dioden 25a-25c eine Überspannungsschutz-Diode 27, bevorzugt eine Zener-Diode oder eine Supressor-Diode, derart parallel geschaltet ist, daß die Überspannungsschutz-Diode 27a-27c die zugeordnete Bypass-Diode 25a-25c überbrückt, wenn eine Überspannung an der betreffenden Bypass-Diode anliegt. Vorteilhafterweise kann jede einzelne der Bypass-Dioden 25a-25c vor Überspannungen geschützt werden, insbesondere, wenn die Überspannung lediglich an einer einzelnen Bypass-Diode anliegt und nicht an allen Bypass-Dioden 25a-25c gleichzeitig bzw. an den Anschlußpolen 19, 21, wie dies z.B. bei Induktionsströmen aufgrund eines Blitzschlages der Fall sein kann.

Die in den beschriebenen Figuren 1 bis 4 gezeigten Ausführungsformen der Anschlußdose 7 weisen Kontaktvorrichtungen 13a-13d auf, welche vorzugsweise einstückig aus Metall hergestellt sind und weiter vorzugsweise einen Klemmbereich für die Bypass-Dioden 25a-25c und/oder die Überspannungsschutz-Diode(n) 27; 27a-27c umfassen. Alternativ können die elektronischen Bauteile, d.h. die Bypass-Dioden 25a-25c und/oder die Überspannungsschutz-Diode(n) 27; 27a-27c, auch auf einer Leiterplatte angeordnet sein. Bevorzugt sind die entsprechenden elektronischen Bauteile in einer Ausführung als SMD Bauteil auf der Leiterplatte angeordnet.

Die vorliegende Erfindung ist nicht auch die obigen, beispielhaft beschriebenen Ausführungsformen beschränkt. Vielmehr können einzelne Elemente und/oder Merkmale eines jeden beschriebenen Aspekts und/oder einer jeden beschriebenen Ausführungsform mit einzelnen Elementen und/oder Merkmalen der weiteren Aspekte und/oder weiteren Ausführungsformen in beliebiger Weise miteinander kombiniert werden und somit weitere Aspekte und/oder Ausführungsformen gebildet werden.

### Bezugszeichenliste

- 1: Solarpaneel
- 3: Solarmodul
- 7: Anschlußdose
- 5a-5d: elektrischer Leiter des Solarmodul 3
- 9: Gehäuse
- 11: Öffnungsbereich
- 13a-13d: Kontaktvorrichtung
- 15a-15d: Leiterkontakt
- 17a, 17d: Anschlußbereich
- 19: Anschlußpol
- 21: Anschlußpol
- 23a-23d: Kurzschlußbereich
- 25a-25c: Bypass-Diode
- 27;27a-27c: Überspannungsschutz-Diode
- 29a-29d: Solarzellengruppe
- I: Stromrichtung

## Patentansprüche

1. Anschlußdose (7) für ein Solarmodul (3) umfassend:
- einen ersten und zweiten elektrischen Anschlußpol (19, 21),
- zumindest drei elektrische Kontaktvorrichtungen (13a, 13b, 13c), wobei jeder der zumindest drei elektrischen Kontaktvorrichtungen (13a, 13b, 13c) mit einem zugeordneten elektrischen Leiter (5a, 5b, 5c) des Solarmoduls (3) kontaktierbar ist,
- zumindest zwei Bypass-Dioden (25a, 25b), wobei die erste der zumindest zwei Bypass-Dioden (25a) die erste Kontaktvorrichtung (13a) mit der zweiten Kontaktvorrichtung (13b) und die zweite der zumindest zwei Bypass-Dioden (25b) die zweite Kontaktvorrichtung (13b) mit der dritten Kontaktvorrichtung (13c) elektrisch verbindet,
**dadurch gekennzeichnet, dass**
- die Anschlußdose (7) zumindest eine Überspannungsschutz-Diode (27) umfasst, wobei die zumindest eine Überspannungsschutz-Diode (27; 27a, 27b, 27c) parallel zu zumindest einer der Bypass-Dioden (25a, 25b) geschaltet ist und
wobei die Ansprechzeit der zumindest einen Überspannungsschutz-Diode (27) kleiner ist als die Ansprechzeit der Bypass-Dioden (25a, 25b), um die Bypass-Dioden (25a, 25b) vor Überspannungen zu schützen.

2. Anschlußdose (7) nach Anspruch 1, wobei genau eine Überspannungsschutz-Diode (27) den ersten Anschlußpol (19) mit dem zweiten Anschlußpol (21) elektrisch verbindet.

3. Anschlußdose (7) nach Anspruch 1, umfassend:
- N elektrische Kontaktvorrichtungen (13a, 13b, 13c, 13d), welche jeweils mit einem zugeordneten elektrischen Leiter (5a) des Solarmoduls (3) kontaktierbar sind,
- N-1 Bypass-Dioden (25a, 25b, 25c), und
- N-1 Überspannungsschutz-Dioden (27a, 27b, 27c),
wobei jeweils zwei elektrische Kontaktvorrichtungen (13a, 13b, 13c, 13d) durch eine Bypass-Diode (25a, 25b, 25c) und eine dazu parallel geschaltete Überspannungsschutz-Diode (27a, 27b, 27c) elektrisch verbunden sind.

4. Anschlußdose (7) nach einem der vorigen Ansprüche, wobei ein Gehäuse der Anschlußdose (7) spritzgegossen ist und wobei die Bypass-Dioden (25a, 25b, 25c) und die Überspannungsschutz-Diode(n) (27; 27a, 27b, 27c) in dem Gehäusematerial der Anschlußdose (7) eingebettet sind und von dem Gehäusematerial der Anschlußdose (7) umgeben sind.

5. Anschlußdose (7) nach einem der vorigen Ansprüche, wobei zumindest zwei der elektrischen Kontaktvorrichtungen (13a, 13b) mittels zumindest einer Überspannungsschutz-Diode (27) mechanisch verbunden sind.

6. Anschlußdose (7) nach einem der vorigen Ansprüche, wobei die Überspannungsschutz-Diode (25) eine Supressor-Diode, eine bipolare Supressor-Diode, eine Zener-Diode, eine Schottky-Diode oder ein Varistor ist.

7. Anschlußdose (7) nach einem der vorigen Ansprüche, wobei die Überspannungsschutz-Diode (27) als SMD-Bauteil ausgebildet ist.

8. Anschlußdose (7) nach einem der vorigen Ansprüche, wobei zumindest zwei der elektrischen Kontaktvorrichtungen (13a, 13b) mittels zumindest einer Bypass-Diode (25a, 25b, 25c) mechanisch verbunden sind.

9. Anschlußdose (7) nach einem der vorigen Ansprüche, wobei die zumindest eine Bypass-Diode (25a, 25b, 25c) und die zumindest eine Überspannungsschutz-Diode (27; 27a, 27b, 27c) an einer Leiterplatte (10) angeordnet sind.

10. Anschlußdose (7) nach einem der vorigen Ansprüche, wobei die Anschlußdose (7) mit einem Kunstharz ausgegossen ist.

11. Solarpaneel (1) umfassend:
- zumindest ein im wesentlichen plattenförmiges Solarmodul (3) und
- zumindest eine Anschlußdose (7) gemäß einem der vorangegangenen Ansprüche,
wobei das Solarmodul (3) zumindest drei elektrische Leiter (5a, 5b, 5c) umfaßt und die zumindest drei elektrischen Leiter (5a, 5b, 5c) jeweils mit einer zugeordneten elektrischen Kontaktvorrichtung (13a, 13b, 153) der Anschlußdose (7) verbunden sind.

12. Verfahren zum Herstellen einer Anschlußdose (7) mit den Schritten:
- Bereitstellen zumindest dreier elektrischer Kontaktvorrichtungen (13a, 13b, 13c), wobei jeder der zumindest drei elektrischen Kontaktvorrichtungen (13a, 13b, 13c) mit einem zugeordneten elektrischen Leiter (5a, 5b, 5c) eines Solarmoduls (3) kontaktierbar ist,
- Anordnen zumindest zweier Bypass-Dioden (25a, 25b) an den zumindest drei elektrischen Kontaktvorrichtungen (13a, 13b, 13c), wobei die erste der zumindest zwei Bypass-Dioden (25a) die erste Kontaktvorrichtung (13a) mit der zweiten Kontaktvorrichtung (13b) und die zweite der zumindest zwei Bypass-Dioden (25b) die zweite Kontaktvorrichtung (13b) mit der dritten Kontaktvorrichtung (13c) elektrisch verbindet,
- Anordnen zumindest einer Überspannungsschutz-Diode (27), wobei die zumindest eine Überspannungsschutz-Diode (27; 27a, 27b, 27c) parallel zu zumindest einer der Bypass-Dioden (25a, 25b) geschaltet ist, und wobei die Ansprechzeit der zumindest einen Überspannungsschutz-Diode (27) kleiner ist als die Ansprechzeit der Bypass-Dioden (25a, 25b), um die Bypass-Dioden (25a, 25b) vor Überspannungen zu schützen, und
- Ausbilden eines Gehäuses der Anschlußdose (7) mittels flüssigem Gehäusematerial, wobei die Bypass-Dioden (25a, 25b, 25c) und die Überspannungsschutz-Diode(n) (27; 27a, 27b, 27c) in dem Gehäusematerial der Anschlußdose (7) eingebettet sind und von dem Gehäusematerial der Anschlußdose (7) umgeben sind.

## Claims

1. A connection socket (7) for a solar module (3), comprising:
- first and second electric terminals (19, 20),
- at least three electric contact devices (13a, 13b, 13c) wherein each one of the at least three electric contact devices (13a, 13b, 13b) is connectable to an associated electric conductor (5a, 5b, 5c) of the solar module (3),
- at least two bypass diodes (25a, 25b) wherein the first one of the at least two bypass diodes (25a) electrically connects the first contact device (13a) to the second contact device (13b), and the second one of the at least two bypass diodes (25b) electrically connects the second contact device (13b) to the third contact device (13c),
**characterized in that**
- the connection socket (7) comprises at least one surge protection diode (27) wherein the at least one surge protection diode (27; 27a; 27b, 27c) is connected in parallel to at least one of the bypass diodes (25a, 25b), and wherein the reaction time of the at least one surge protection diode (27) is shorter than the reaction time of the bypass diodes (25a, 25b) so as to protect the bypass diodes (25a, 25b) from electrical surges.

2. The connection socket (7) according to claim 1, wherein exactly one surge protection diode (27) electrically connects the first terminal (19) to the second terminal (21).

3. The connection socket (7) according to claim 1, comprising:
- N electric contact devices (13a, 13b, 13c, 13d) each being connectable to an associated electric conductor (5a) of the solar module (3),
- N-1 bypass diodes (25a, 25b, 25c), and
- N-1 surge protection diodes (27a, 27b, 27c),
wherein respective pairs of electric contact devices (13a, 13b, 13c, 13d) are electrically connected by a bypass diode (25a, 25b, 25c) and a surge protection diode (27a, 27b, 27c) connected in parallel thereto.

4. The connection socket (7) according to any one of the preceding claims, wherein a housing of the connection socket (7) is injection molded, and wherein the bypass diodes (25a, 25b, 25c) and the surge protection diode(s) (27; 27a, 27b, 27c) are embedded in the housing material of the connection socket (7) and are surrounded by the housing material of the connection socket (7).

5. The connection socket (7) according to any one of the preceding claims, wherein at least two of the electric contact devices (13a, 13b) are mechanically connected by means of at least one surge protection diode (27).

6. The connection socket (7) according to any one of the preceding claims, wherein the surge protection diode (25) is a suppressor diode, a bipolar suppressor diode, a Zener diode, a Schottky diode, or a varistor.

7. The connection socket (7) according to any one of the preceding claims, wherein the surge protection diode (27) is formed as an SMD component.

8. The connection socket (7) according to any one of the preceding claims, wherein at least two of the electric contact devices (13a, 13b) are mechanically connected by means of at least one bypass diode (25a, 25b, 25c).

9. The connection socket (7) according to any one of the preceding claims, wherein the at least one bypass diode (25a, 25b, 25c) and the at least one surge protection diode (27; 27a, 27b, 27c) are disposed on a printed circuit board (10).

10. The connection socket (7) according to any one of the preceding claims, wherein the connection socket (7) is filled with a synthetic resin.

11. A solar panel (1) comprising:
at least one substantially plate-shaped solar module (3) and
at least one connection socket (7) according to any one of the preceding claims,
wherein the solar module (3) comprises at least three electric conductors (5a, 5b, 5c) and wherein the at least three electric conductors (5a, 5b, 5c) are each connected to an associated electric contact device (13a, 13b, 153) of the connection socket (7).

12. A method of producing a connection socket (7), comprising the steps of:
- providing at least three electric contact devices (13a, 13b, 13c) wherein each of the at least three electric contact devices (13a, 13b, 13c) is engageable to an associated electrical conductor (5a, 5b, 5c) of a solar module (3),
- arranging at least two bypass diodes (25a, 25b) at the at least three electric contact devices (13a, 13b, 13c) wherein the first one of the at least two bypass diodes (25a) electrically connects the first contact device (13a) to the second contact device (25b), and the second one of the at least two bypass diodes 825b) connects the second contact device (13b) to the third contact device (13c),
- arranging at least one surge protection diode (27) wherein the least one surge protection diode (27; 27a, 27b, 27c) is connected in parallel to at least one of the bypass diodes (25a, 25b), and wherein the reaction time of the at least one surge protection diode (27) is shorter than the reaction time of the bypass diodes (25a, 25b) so as to protect the bypass diodes (25a, 25b) from electrical surges, and
- forming a housing of the connection socket (7) by means of liquid housing material, wherein the bypass diodes (25a, 25b, 25c) and the surge protection diode(s) (27; 27a, 27b, 27c) are embedded in the housing material of the connection socket (7) and are surrounded by the housing material of the connection socket (7).

## Revendications

1. Boîte de jonction (7) pour un module solaire (3) comprenant :
- une première et seconde borne de raccordement électrique (19, 21),
- au moins trois dispositifs de contact électriques (13a, 13b, 13c), dans laquelle chacun des au moins trois dispositifs de contact électriques (13a, 13b, 13c) peut venir en contact avec un conducteur électrique associé (5a, 5b, 5c) du module solaire (3),
- au moins deux diodes de dérivation (25a, 25b), dans laquelle la première des au moins deux diodes de dérivation (25a) connecte électriquement le premier dispositif de contact (13a) au deuxième dispositif de contact (13b) et la seconde des au moins deux diodes de dérivation (25b) connecte électriquement le deuxième dispositif de contact (13b) au troisième dispositif de contact (13c), **caractérisée en ce que**
- la boîte de jonction (7) comprend au moins une diode de protection contre les surtensions (27), dans laquelle l'au moins une diode de protection contre les surtensions (27 ; 27a, 27b, 27c) est montée en parallèle à au moins une des diodes de dérivation (25a, 25b) et
dans laquelle la durée de réponse de l'au moins une diode de protection contre les surtensions (27) est inférieure à la durée de réponse des diodes de dérivation (25a, 25b) pour protéger les diodes de dérivation (25a, 25b) de surtensions.

2. Boîte de jonction (7) selon la revendication 1, dans laquelle exactement une diode de protection contre les surtensions (27) connecte électriquement la première borne de raccordement (19) à la seconde borne de raccordement (21).

3. Boîte de jonction (7) selon la revendication 1, comprenant :
- N dispositifs de contact électriques (13a, 13b, 13c, 13d) qui peuvent chacun venir en contact avec un conducteur électrique associé (5a) du module solaire (3),
- N-1 diodes de dérivation (25a, 25b, 25c), et
- N-1 diodes de protection contre les surtensions (27a, 27b, 27c),
dans laquelle deux dispositifs de contact électriques (13a, 13b, 13c, 13d) sont à chaque fois connectés électriquement par une diode de dérivation (25a, 25b, 25c) et une diode de protection contre les surtensions (27a, 27b, 27c) montée en parallèle à celle-ci.

4. Boîte de jonction (7) selon une des revendications précédentes, dans laquelle un logement de la boîte de jonction (7) est moulé par injection, et dans laquelle les diodes de dérivation (25a, 25b, 25c) et la/les diode(s) de protection contre les surtensions (27 ; 27a, 27b, 27c) sont encastrées dans le matériau de logement de la boîte de jonction (7) et sont entourées par le matériau de logement de la boîte de jonction (7).

5. Boîte de jonction (7) selon une des revendications précédentes, dans laquelle au moins deux des dispositifs de contact électriques (13a, 13b) sont connectés mécaniquement au moyen d'au moins une diode de protection contre les surtensions (27).

6. Boîte de jonction (7) selon une des revendications précédentes, dans laquelle la diode de protection contre les surtensions (25) est une diode suppresseuse de surtension, une diode suppresseuse de surtension bipolaire, une diode Zener, une diode Schottky ou un varistor.

7. Boîte de jonction (7) selon une des revendications précédentes, dans laquelle la diode de protection contre les surtensions (27) est réalisée en tant que composant CMS.

8. Boîte de jonction (7) selon une des revendications précédentes, dans laquelle au moins deux des dispositifs de contact électriques (13a, 13b) sont connectés mécaniquement au moyen d'au moins une diode de dérivation (25a, 25b, 25c).

9. Boîte de jonction (7) selon une des revendications précédentes, dans laquelle l'au moins une diode de dérivation (25a, 25b, 25c) et l'au moins une diode de protection contre les surtensions (27 ; 27a, 27b, 27c) sont disposées sur une plaquette (10).

10. Boîte de jonction (7) selon une des revendications précédentes, dans laquelle la boîte de jonction (7) est coulée avec une résine synthétique.

11. Panneau solaire (1) comprenant :
- au moins un module solaire (3) essentiellement en forme de plaque et
- au moins une boîte de jonction (7) selon une des revendications précédentes, dans lequel le module solaire (3) comprend au moins trois conducteurs électriques (5a, 5b, 5c) et les au moins trois conducteurs électriques (5a, 5b, 5c) sont chacun connectés à un dispositif de contact électrique associé (13a, 13b, 153) de la boîte de jonction (7).

12. Procédé de fabrication d'une boîte de jonction (7) avec les étapes :
- mise à disposition d'au moins trois dispositifs de contact électriques (13a, 13b, 13c), dans lequel chacun des au moins trois dispositifs de contact électriques (13a, 13b, 13c) peut venir en contact avec un conducteur électrique associé (5a, 5b, 5c) d'un module solaire (3),
- disposition d'au moins deux diodes de dérivation (25a, 25b) sur les au moins trois dispositifs de contact électriques (13a, 13b, 13c), dans lequel la première des au moins deux diodes de dérivation (25a) connecte électriquement le premier dispositif de contact (13a) au deuxième dispositif de contact (13b) et la seconde des au moins deux diodes de dérivation (25b) connecte électriquement le deuxième dispositif de contact (13b) au troisième dispositif de contact (13c),
- disposition d'au moins une diode de protection contre les surtensions (27), dans lequel l'au moins une diode de protection contre les surtensions (27 ; 27a, 27b, 27c) est montée en parallèle à au moins une des diodes de dérivation (25a, 25b), et dans lequel la durée de réponse de l'au moins une diode de protection contre les surtensions (27) est inférieure à la durée de réponse des diodes de dérivation (25a, 25b) pour protéger les diodes de dérivation (25a, 25b) de surtensions, et
- réalisation d'un logement de la boîte de jonction (7) au moyen de matériau de logement liquide, dans lequel les diodes de dérivation (25a, 25b, 25c) et la/les diode(s) de protection contre les surtensions (27 ; 27a, 27b, 27c) sont encastrées dans le matériau de logement de la boîte de jonction (7) et sont entourées par le matériau de logement de la boîte de jonction (7).
